**Europäisches Patentamt**

**European Patent Office**

**Office européen des brevets**

(19)

(11) Veröffentlichungsnummer: **0 062 152**
**B1**

(12) # EUROPÄISCHE PATENTSCHRIFT

(45) Veröffentlichungstag der Patentschrift:
22.07.87

(51) Int. Cl.⁴: **G 01 D 5/244**

(21) Anmeldenummer: **82101157.4**

(22) Anmeldetag: **17.02.82**

(54) Verfahren zum Ansteuern eines analogen Anzeigeinstruments in Kraftfahrzeugen.

(30) Priorität: **24.03.81 DE 3111465**

(43) Veröffentlichungstag der Anmeldung:
**13.10.82 Patentblatt 82/41**

(45) Bekanntmachung des Hinweises auf die Patenterteilung:
**22.07.87 Patentblatt 87/30**

(84) Benannte Vertragsstaaten:
**AT DE FR GB IT SE**

(56) Entgegenhaltungen:
**CH-A-493 173**
**DE-A-595 939**
**FR-A-999 252**
**US-A-2 604 528**

**H. SCHMID: "Electronic Analog/Digital
Converters", 1970, pages 206,207,226,227, Nostrand,
New York, USA**

(73) Patentinhaber: **BAYERISCHE MOTOREN WERKE
Aktiengesellschaft, Postfach 40 02 40 Petuelring
130 - AJ- 36, D-8000 München 40 (DE)**

(72) Erfinder: **Deicke, Axel, Dipl.- Ing., Hamsterweg 9,
D-8011 Baldham (DE)**

(74) Vertreter: **Bullwein, Fritz, Bayerische Motoren
Werke Aktiengesellschaft Postfach 40 02 40 - AJ-
23 Petuelring 130, D-8000 München 40 (DE)**

EP 0 062 152 B1

## Beschreibung

Die Erfindung bezieht sich auf ein Verfahren zum Ansteuern mehrerer analoger Anzeigeinstrumente, denen Geber zugeordnet sind, die Folgen von entsprechend den Meßwerten modulierten Impulsen liefern.

Ein derartiges Verfahren ist im Stand der Technik allgemein bekannt. Bei derartigen herkömmlichen Verfahren zum Ansteuern eines analogen Anzeigeinstruments muß zunächst das digitale Ausgangssignal über einen Digital-/Analog-Wandler geführt werden. Dieser hat eine begrenzte Genauigkeit und muß außerdem noch zusätzlich gegen Spannungs- und Temperaturschwankungen kompensiert werden. Ferner entsteht durch die immer vorhandene Lagerreibung in den Meßwerken eine ruckartige Anzeige, da das Instrument infolge seiner Haftreibung erst auf eine Mindeständerung des vom Wandler gelieferten Meßstroms mit einer sichtbaren Ausschlagänderung reagiert. Es ist in diesem Zusammenhang bekannt, ein analoges Anzeigeinstrument in der Weise anzusteuern, daß ein als Impulsfolge vorliegender Meßwert mit Hilfe einer durch ein Relais gebildeten Stromverstärkungsschaltung in eine Folge von Strompulsen vorgegebener Impulshöhe umgesetzt und die zeitintegrierte Stromimpulsfolge auf das Anzeigeinstrument gegeben wird (DE-PS 595 939).

Der Erfindung liegt die Aufgabe zugrunde, ein Verfahren der eingangs genannten Art zu schaffen, bei dem eine Umwandlung der digitalen Ausgangssignale nicht erforderlich ist und das eine exakte Anzeige dieser Ausgangssignale auf den Anzeigeinstrumenten frei von Reibungseinflüssen gewährleistet.

Die Erfindung löst diese Aufgabe dadurch, daß diese Impulsfolgen durch getaktetes Einschalten derselben Konstant-Stromquelle erzeugt, nach dem Impulszeitverfahren übertragen und den zugehörigen Anzeigeinstrumenten kanalweise abwechselnd zugeführt werden, wobei die Eigenfrequenz der Anzeigeinstrumente wesentlich kleiner als die Frequenz der Impulse ist.

Durch die kanalweise Direktbeaufschlagung jedes Anzeigeinstruments mmit einer Impulsfolge wird ein Digital-/Analog-Wandler überflüssig.

Die Haftreibung des jeweiligen Instruments hat keinen Einfluß, da die Impulse so gewählt werden können daß jeder für sich einen die Haftreibung überwindenden Meßstrom liefert. Der große Unterschied zwischen der Eigenfrequenz des Anzeigeinstruments und der Impulsfolgefrequenz bewirkt, daß die Anzeigeinstrumente zwischen zwei aufeinander folgenden Impulsen bzw. Impulsfolgen nicht abfallen, sondern sich aufgrund ihrer Trägheit auf einem durch den Modulationsinhalt der Impulse bestimmten Werte halten. Dieser Wert ist durch die Amplitude und Länge der Impulse bestimmt. Die Impulse können dabei in bekannter Weise z.B. Rechteck-, Dreieck-, Sägezahn- oder Glockenform besitzen.

Die Vorteile des erfindungsgemäßen Verfahrens zum Ansteuern mehrerer analoger Anzeigeinstrumente bestehen im wesentlichen in dem geringen Aufwand. Die von den zugeordneten Gebern gelieferten Folgen von entsprechend den Meßwerten modulierten Impulse werden nach dem Impulszeitverfahren übertragen und den zugehörigen Anzeigeinstrumenten zugeführt. Unter Impulszeitverfahren ist ein diskretes Modulationsverfahren für die Mehrfachausnutzung nach dem Zeitmultiplex-Prinzip bekannt. Dieses Verfahren besteht darin, daß mehrere modulierte Pulse ineinander geschachtelt werden und die so ineinander geschachtelten Impulsfolgen für einen gemeinsamen Kanal übertragen werden. In der Anwendung auf Kraftfahrzeuge bedeutet dies, daß zum Übertragen der Impulsfolgen lediglich eine einzige Leitung vorzusehen ist. Im Gegensatz zur herkömmlichen Ansteuerung mehrerer analoger Anzeigeinstrumente über separate Digital/Analog-Wandler und jeweils eine Leitung ergibt sich dadurch eine enorme Ersparnis an Bauteilen und Leitungen.

Um eine ausreichende Ansteuerung der Anzeigeinstrumente zu gewährleisten, ist die Kanalschaltdauer für das Impulszeitverfahren den maximalen anzuzeigenden Meßwerten entsprechend gewählt. Unter Kanalschaltdauer ist bekanntermaßen die Zeit zu verstehen, in der die einzelnen Impulse übertragen werden. Somit läßt sich erreichen, daß Meßwerte bis hin zum Vollausschlag der Anzeigeinstrumente übertragen werden können.

Die verschiedenen Impulsfolgefrequenzen sollten aus schaltungsökonomischen Gründen Werte besitzen, die im Verhältnis ganzer Zahlen zueinander stehen. Der Schaltungsaufwand läßt sich dann besonders geringhalten, wenn die Frequenzen der Impulsfolgen gleich sind.

Diese Frequenzen können zusätzlich auch konstant sein. Im Gegensatz zu einer Änderung der Impulsfolgefrequenzen, beispielsweise bei großen zu übertragenden Meßwerten, sind dann gesonderte Frequenzwähler entbehrlich. Ferner kann in diesem Fall die Impulsfolge durch eine einzige, impulsförmig eingeschaltete Konstant-Stromquelle geliefert werden. Der Vorteil des geringen schaltungstechnischen Aufwands tritt dabei klar zu Tage.

Zur Ansteuerung der Stromquelle kann mit Hilfe eines gemeinsamen Abwärtszählers die Einschaltdauer der Stromquelle bestimmt werden. Der Abwärtszähler ist nacheinander mit den Ausgangssignalen der Geber geladen und wird innerhalb der Kanalschaltdauer mit konstanter Frequenz auf Null heruntergezählt. Die Steuerung der Ladung der Zählung und die Taktvorgabe für das Herunterzählen kann auf einfache Weise mit Hilfe eines Mikroprozessors durchgeführt werden.

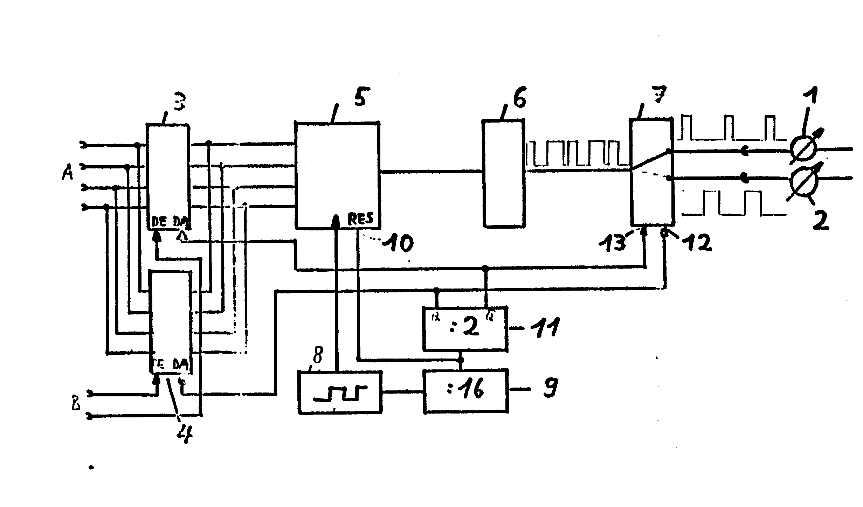

In der Zeichnung ist ein Ausführungsbeispiel der Erfindung beschrieben. Diese zeigt eine Schaltung, mit der mehrere analoge Anzeigeinstrumente direkt mit Impulsfolgen entsprechend den digitalen Ausgangssignalen von Gebern beaufschlagt werden.

Die der Einfachheit halber nur für zwei analoge Anzeigeinstrumente für z. B. Drehzahl und Kraftstoffverbrauch dargestellte Schaltung enthält neben den beiden analogen Anzeigeinstrumenten 1 und 2 zwei Speicher 3 und 4, die abwechselnd mit den am Eingang A anstehenden, binären Ausgangssignalen zweier nicht dargestellter Geber für Drehzahl und Kraftstoffverbrauch geladen werden.

Den Speichern 3 und 4 nachgeschaltet ist ein Abwärtszähler 5, eine Konstant-Stromquelle 6 und ein Umschalter 7. Ein Taktgenerator 8 steuert einerseits den Abwärtszähler 5 direkt und über einen Teiler 9 auch dessen Rücksitzeingang 10 und ferner über ein Flip-Flop 11 die Speicher 3 und 4 und den Umschalter 7. Dabei ist der Ausgang Q des Flip-Flops 11 mit dem Eingang DA (= Daten-aus) des Speichers 4 und einem Eingang 12 des Umschalters 7 verbunden, der dem Anzeigeinstrument 2 zugeordnet ist. Der Ausgang Q̄ des Flip-Flops 11 ist mit dem Eingang DA des Speichers 3 und einem Eingang 13 des Umschalters 7 verbunden, der dem Anzeigeinstrument 1 zugeordnet ist. Weitere Eingänge DE (Daten-ein) der Speicher 3 und 4 werden abwechselnd über einen Eingang B der Schaltung angesteuert. Über die beiden Eingänge B wird der jeweils zu adressierende Speicher angesteuert, wenn der zu übernehmende Datensatz am Eingang A ansteht.

Über den Eingang A werden die binären Ausgangssignale der beiden Geber abwechselnd in den jeweils zugeordneten Speicher 3 bzw. 4 eingelesen. Der Taktgenerator 8 erzeugt ein Rechtecksignal (Impuls-/Pausen-Verhältnis 1 : 1) mit einer Periodenlänge von z. B. 250 μ. Damit wird der Abwärtszähler 5 über den Teiler 9 alle 4 ms. zurückgesetzt und abwechselnd mit einem neuen Signal entsprechend dem Inhalt der Speicher 3 bzw. 4 geladen. Das zu ladende Signal wird dabei über das Flip-Flop 11 durch Ansteuerung der Eingänge DA der Speicher 3 und 4 ausgewählt.

Der Abwärtszähler 5 aktiviert die Stromquelle 6 so lange, bis das aus den Speichern 3 und 4 übernommene Signal auf Null heruntergezählt hat (down-counter). Gleichzeitig wird über den Umschalter 7 das analoge Anzeigeinstrument angewählt, dessen in den Speichern 3 bzw. 4 enthaltener Wert gerade in den Abwärtszähler 5 übernommen wurde. Auf diese Weise liefert die Stromquelle 6 Impulse entsprechend zweier ineinandergeschachtelten Impulsfolgen gleicher Freqenz an den Umschalter 7. Dieser führt die eine Impulsfolge mit den z. B. geradzahligen Impulsen dem Anzeigeinstrument 1, die zweite Impulsfolge mit den ungeradzahligen Impulsen dem Anzeigeinstrument 2 zu.

Durch die vorgesehene Umwandlung digitaler Ausgangssignale von mehreren Gebern und deren ggf. erforderliche Umwandlung in eine Impulsfolge mit Impulsen konstanter Amplitude, deren Länge dem anzuzeigenden Meßwert (= Ausgangssignal der Geber) entspricht und die Übertragung der Impulsfolgen nach dem Impulszeitverfahren können analoge Anzeigeinstrumente in digitaler Form direkt angesteuert werden. Voraussetzung ist hierfür lediglich, daß die Eigenfrequenz der Anzeigeinstrumente wesentlich kleiner als die Folgefrequenz der Impulse ist. Infolge der Trägheit analoger Anzeigeinstrumente bleibt der angezeigte Meßwert auch in den Impulspausen, in denen die Impulse für die anderen Anzeigeinstrumente übertragen werden, unverändert stehen. Im vorliegenden Fall ist diese Bedingung erfüllt, da die Impulsfolgefrequenz 125 Hz beträgt und damit wesentlich größer als die in der Größenordnung von einigen Hz liegende Eigenfrequenz analoger Anzeigeinstrumente ist. Wie zu erkennen, können die Impulsfolgen und damit die Meßwerte einkanalig übertragen werden; dies ist durch die dargestellte eine Leitung zwischen der Stromquelle 6 und dem Umschalter 7 zu erkennen. Hinzu kommen lediglich zwei Steuerleitungen wesentlich geringeren Querschnittes für die Ansteuerung der Eingänge 12 und 13 des Umschalters 7 durch das Flip-Flop 11. Das Fehlen jeglicher Digital-/Analog-Wandler ist ebenfalls deutlich zu erkennen. Selbstverständlich ist es zusätzlich möglich, die Steuerung der Schaltung mit Hilfe eines Mikroprozessors vorzunehmen.

**Patentansprüche**

1. Verfahren zum Ansteuern mehrerer analoger Anzeigeinstrumente, denen Geber zugeordnet sind, die Folgen von entsprechend den Meßwerten modulierten Impulsen liefern, dadurch gekennzeichnet, daß diese Impulsfolgen durch getaktetes Einschalten derselben Konstant-Stromquelle erzeugt, nach dem Impulszeitverfahren übertragen und den zugehörigen Anzeigeinstrumenten (1, 2) kanalweise abwechselnd zugeführt werden, wobei die Eigenfrequenz der Anzeigeinstrumente wesentlich kleiner als die Folgefrequenz der Impulse ist.

2. Verfahren nach Anspruch 1, dadurch gekennzeichnet, daß die Kanalschaltdauer den maximalen anzuzeigenden Meßwerten entspricht.

3. Verfahren nach Anspruch 1 oder 2, dadurch gekennzeichnet, daß die Frequenzen der Impulsfolgen gleich sind.

4. Verfahren nach einem der Ansprüche 1 bis 3, dadurch gekennzeichnet, daß die Frequenzen der Impulsfolgen konstant sind.

5. Verfahren nach einem der Ansprüche 1 bis 4, dadurch gekennzeichnet, daß die Einschaltdauer der Stromquelle (6) durch einen gemeinsamen Abwärtszähler (5) bestimmt wird, der nacheinander mit den Ausgangssignalen der Geber geladen und innerhalb der
Kanalschaltdauer mit konstanter Frequenz auf
Null heruntergezählt wird.

### Claims

1. A method of actuating a plurality of analog indicator instruments which are associated with sensors which deliver sequences of modulated pulses according to the measured values, characterised in that these pulse sequences are generated by timed switching-on of the same constant current source, transmitted according to the pulse-time method and fed alternately by channels to the respective indicator instruments (1, 2), the natural frequency of the indicator instruments being substantially lower than the sequence frequency of the pulses.

2. A method according to Claim 1, characterised in that the channel-switching duration corresponds to the maximum measured values to be indicated.

3. A method according to Claim 1 or 2, characterised in that the frequencies of the pulse sequences are equal.

4. A method according to any one of Claims 1 to 3, characterised in that the frequencies of the pulse sequences are constant.

5. A method according to any one of Claims 1 to 4, characterised in that the switch-on duration of the current source (6) is determined by a common downward counter (5) which is successively charged with the output signals of the sensors and counted down to zero with constant frequency within the channel-switching duration.

### Revendications

1. Procédé pour commander plusieurs instrumente d'affichage analogique, auxquels sont associés des émetteurs qui délivrent des successions d'impulsions modulées en fonction des valeurs de mesure, procédé caractérisé en ce que ces successions d'impulsions sont produites par la mise en circuit synchronisée de la même source de courant constant, sont transmises selon le procédé de modulation par les durées d'impulsions, et sont amenées aux instruments d'affichage correspondants (1, 2) alternativement par des canaux, la fréquence propre des instruments d'affichage étant sensiblement inférieure à la fréquence de successions des impulsions.

2. Procédé selon la revendication 1, caractérisé en ce que la durée de commutation des canaux correspond aux valeurs maximales de mesures à afficher.

3. Procédé selon la revendication 1 ou 2, caractérisé en ce que les fréquences des successions d'impulsions sont identiques.

4. Procédé selon une des revendications 1 à 3, caractérisé en ce que les fréquences des successions d'impulsions sont constantes.

5. Procédé selon une des revendications 1 à 4, caractérisé en ce que la durée de mise en circuit de la source de courant (6) est déterminée par un compteur commun (5) qui est chargé successivement par les signaux de sortie des émetteurs et qui décompte ensuite jusqu'à zéro à une fréquence constante à l'intérieur de la durée de commutation des canaux.

0 062 152